# FASCICULE DE BREVET EUROPEEN

(11) **EP 1 467 947 B1**
(45) Date de publication et mention de la délivrance du brevet: **27.07.2016**
(21) Numéro de dépôt: 02806329.5
(22) Date de dépôt: 17.12.2002
(51) Int. Cl.: B81B 7/00

(54) **PROCÉDÉ ET ZONE DE SCELLEMENT ENTRE DEUX SUBSTRATS D'UNE MICROSTRUCTURE**
VERFAHREN UND BEREICH ZUR ABDICHTUNG ZWISCHEN ZWEI MIKROSTRUKTUR-SUBSTRATEN
METHOD AND ZONE FOR SEALING BETWEEN TWO MICROSTRUCTURE SUBSTRATES

(30) Priorité: 28.12.2001 FR 0117015
(43) Date de publication de la demande: 20.10.2004
(73) Titulaire: Commissariat à l'Énergie Atomique et aux Énergies Alternatives, 75015 Paris (FR)
(72) Inventeur: DIEM, Bernard, F-38130 Echirolles (FR); CAPLET, Stéphane, F-38360 Sassenage (FR); DELAYE, Marie-Thérèse, F-38600 Fontaine (FR)
(74) Mandataire: Santarelli
(86) Numéro de dépôt international: PCT/FR2002/004383
(87) Numéro de publication internationale: WO 2003/059806

(56) Documents cités:
- EP-A- 0 982 773
- US-A- 5 668 033
- US-A1- 2001 021 570
- US-B1- 6 294 402
- PATENT ABSTRACTS OF JAPAN vol. 1998, no. 09, 31 juillet 1998 (1998-07-31) -& JP 10 112548 A (DENSO CORP), 28 avril 1998 (1998-04-28)

## Description

L'invention se rapporte au scellement hermétique entre deux parties d'une microstructure, par exemple un dispositif électro-mécanique ou électro-optique, de manière à créer à l'intérieur de cette microstructure une enceinte isolée de l'extérieur. L'invention concerne également la fabrication collective de telles microstructures.

Le domaine général de l'invention est celui de la fabrication collective de microstructures incorporant le plus souvent des composants rapportés, à partir de substrats (« *wafer level* » en anglais) au moyen des techniques de la microélectronique (dépôt et gravure de couches, photolithographie, et ainsi de suite).

Comme exemple d'une telle microstructure, on peut citer l'accéléromètre divulgué dans le brevet FR 2 558 263. Cet accéléromètre comprend, au sein d'une couche mince, une première partie découpée dans cette couche mince et une seconde partie constituée par le reste de la couche mince, la première partie étant reliée à la seconde au moyen de poutrelles flexibles permettant à cette première partie, ou partie « sensible », de se déplacer avec une certaine amplitude dans le plan de la couche mince. Ce dispositif sert à mesurer les accélérations d'un système quelconque dont il est solidaire, au moyen d'une variation de capacité électrique causée par ledit déplacement.

Pour minimiser le coût de fabrication par microtechnologie d'un tel accéléromètre, il est nécessaire que la puce élémentaire possède une surface aussi faible que possible. Cela implique que ladite partie sensible, qui sert de masse sismique, soit très petite (sa masse est classiquement de l'ordre du mg). De plus, l'on fait le vide autour d'elle de manière à supprimer les collisions avec des molécules d'air, qui causeraient des accélérations parasites de la masse sismique d'autant plus gênantes que cette masse sismique est faible.

Dans le cas d'un tel microcomposant, comme dans bien d'autres, il est donc nécessaire de pouvoir maintenir le vide dans une enceinte aménagée dans la microstructure et dans laquelle on a placé le microcomposant. Dans le cadre de l'invention, on supposera que, pour former la microstructure ou une partie de cette microstructure, l'on assemble au moins deux « substrats » contenant chacun une portion de paroi de ladite enceinte.

Le but de l'invention est donc de sceller un tel assemblage de manière hermétique.

Le moyen utilisé pour ce faire doit évidemment être tel qu'il ne gêne en rien le fonctionnement de ce microcomposant, par exemple en émettant un gaz quelconque. De plus, ce moyen de scellement doit être robuste mécaniquement, quelle que soit la température à laquelle la microstructure pourrait être exposée dans les étapes ultérieures de fabrication. Enfin, ce moyen de scellement doit être de réalisation simple et peu coûteuse dans le cadre d'une fabrication collective utilisant les techniques classiques de la microélectronique.

On connaît, dans ce but, un procédé d'assemblage de puces par « soudure eutectique à l'or », qui tire profit de l'existence d'un minimum de la ligne de liquidus dans le diagramme de phase or-silicium, minimum situé à 363 °C et avec une proportion atomique en silicium égale à 31%. Selon l'article de R.F. Wolffenbuttel intitulé « *Low-Temperature Silicon Wafer-to-Wafer Bonding using Metal Intermediate Layers* », Eurosensors X, Leuven, Belgique, 8-11 septembre 1996, ce procédé est classiquement mis en oeuvre selon deux modes de réalisation.

Dans le premier mode de réalisation, l'on dépose simplement une couche d'or, par exemple par évaporation, à la surface des substrats à souder avant de les assembler. Mais ce mode de réalisation a pour inconvénient qu'il faut travailler sous vide ou sous atmosphère d'azote, afin d'éviter la formation d'une couche d'oxyde de silicium à la surface de ces substrats avant assemblage, car cette couche de SiO₂ empêcherait l'obtention de la soudure eutectique.

Dans le second mode de réalisation, l'on dépose au préalable à la surface de chaque substrat une couche de protection. Pour effectuer la soudure, on dépose sur chaque substrat une couche d'or, puis on assemble les substrats en insérant une couche de silicium. Le scellement résulte donc de ce sandwich Au-Si-Au, dont les proportions sont choisies voisines des proportions eutectiques afin d'obtenir un scellement robuste à une température relativement basse. Pour éviter que l'or d'une part, et le silicium des substrats d'autre part, ne diffusent l'un dans l'autre à travers la couche de protection, cette dernière est faite d'une matière faisant office de barrière de diffusion, habituellement un métal tel que le titane ou le chrome. Outre le fait qu'un tel procédé comporte de nombreuses étapes technologiques (notamment le dépôt d'une couche barrière à la surface de chaque substrat), il s'avère que la fiabilité de la soudure ainsi réalisée est médiocre.

Par ailleurs, le document US 6 555 901 enseigne d'utiliser du titane déposé sous la couche d'or d'un premier substrat pour réduire l'oxyde de silicium formé spontanément à la surface du silicium porté par un deuxième substrat.

Enfin, le document « Low-temperature silicon wafer-to-wafer bonding using gold at eutectic température » de Wolfenbuttel et Wise, publié en 1994 dans Sensors and Actuators A, 43, 223, est un document de recherche théorique relatant une étude sur l'effet de la température dans la formation d'une liaison eutectique Au-Si.

Pour éviter ces inconvénients, l'invention propose en revendication 1 un procédé de scellement de deux substrats dans une microstructure, ledit procédé de scellement étant remarquable en ce qu'il comprend les étapes suivantes :
- on dépose à la surface d'un premier substrat un premier liseré comprenant un liseré « supérieur » constitué d'une couche de matériau de scellement apte à interdiffuser spontanément avec la matière du second substrat, et un liseré « inférieur » constitué d'une matière d'adhésion apte à faire adhérer ledit premier substrat avec ledit matériau de scellement, et l'on dépose, à la surface d'au moins une protubérance formée sur ledit second substrat en regard du premier liseré, un second liseré constitué d'une couche dudit matériau de scellement,
- on met au contact les deux parties à assembler, et
- on chauffe la zone de scellement de manière à obtenir l'interdiffusion du matériau de scellement avec la matière du second substrat.

Par exemple, le second substrat pourra être en silicium, et le matériau de scellement pourra être de l'or ; on tirera alors profit de ce que le silicium et l'or ont une forte tendance à diffuser l'un dans l'autre, comme rappelé ci-dessus.

Grâce à ces dispositions, on obtient un scellement ayant toutes les propriétés mentionnées ci-dessus comme étant souhaitables. Notamment, la protubérance aménagée sur le second substrat a pour effet, en premier lieu, de canaliser la diffusion du matériau de scellement de manière à favoriser une diffusion en profondeur ; en second lieu, elle a pour effet d'accroître la pression exercée sur !a surface de contact lors de l'assemblage, du fait de la taille réduite de cette surface de contact.

Les inventeurs ont constaté que le scellement ainsi obtenu était très fiable. Ce dernier point est une bonne surprise. On pouvait s'attendre en effet, avec par exemple les substances citées, à ce que le silicium du second substrat diffuse à travers l'or du liseré déposé sur une protubérance de ce second substrat. Il s'ensuivrait la formation à la surface de ce liseré d'une couche d'oxyde de silicium. Quant ensuite on applique les deux substrats l'un contre l'autre, l'homme du métier s'attendrait, comme expliqué ci-dessus, à ce que cette couche d'oxyde de silicium nuise à la fiabilité de la liaison ainsi réalisée. Celle-ci s'est au contraire révélée être très fiable et robuste.

On notera enfin que tous ces effets sont obtenus sans qu'il soit nécessaire de contrôler de manière très précise la quantité de matériau de scellement.

Dans certaines applications, il pourra se trouver que le matériau de scellement et le premier substrat choisis par l'homme du métier ont la capacité de diffuser l'un dans l'autre : c'est par exemple le cas si d'une part le matériau de scellement est de l'or, et d'autre part le premier substrat est en silicium. Selon des caractéristiques particulières de l'invention, on choisira alors de préférence un liseré inférieur constitué d'une matière apte à faire barrière à cette diffusion. En variante, on inclura dans ledit premier liseré, entre ledit liseré inférieur et ledit liseré supérieur, une couche faisant barrière à cette diffusion. Cette couche barrière pourra par exemple être en tungstène. Avantageusement, cette barrière contribuera à l'effet obtenu par la protubérance selon l'invention, à savoir la canalisation de la diffusion du matériau de scellement à l'intérieur du second substrat.

Corrélativement, l'invention concerne une zone de scellement entre deux substrats d'une microstructure, ladite zone de scellement étant remarquable en ce qu'elle comprend au moins les parties suivantes :
- sur un premier substrat, un liseré « inférieur » constitué d'une matière d'adhésion apte à faire adhérer ledit premier substrat avec un matériau de scellement, ledit matériau de scellement étant apte à interdiffuser spontanément avec la matière du second substrat,
- sur ledit liseré inférieur, une couche dudit matériau de scellement, et
- sur ladite couche de matériau de scellement, une protubérance formée sur ledit second substrat et contenant une certaine quantité de matériau de scellement.

Dans le cas où ledit matériau de scellement et la matière dudit premier substrat sont de nature à pouvoir diffuser l'un dans l'autre, on choisira de préférence un liseré inférieur constitué d'une matière apte à faire barrière à cette diffusion. En variante, ladite zone de scellement comprendra en outre, entre ledit liseré inférieur et ladite couche de matériau de scellement, une couche faisant barrière à cette diffusion. Par exemple, si les deux substrats sont en silicium, on pourra prendre de l'or comme matériau de scellement et une couche barrière faite de tungstène.

Selon des caractéristiques préférentielles, ladite surface de la protubérance n'est pas plane, mais présente un certain nombre de creux.

Grâce à ces dispositions, lors de la mise en oeuvre du procédé de soudure décrit succinctement ci-dessus, on maintient en place dans ces creux une partie du matériau de scellement fondu, et on évite ainsi que ce matériau de scellement soit refoulé latéralement du fait de la pression de contact appliquée lors de l'assemblage, au lieu de diffuser dans l'épaisseur de ladite protubérance.

Selon d'autres caractéristiques préférentielles, ladite surface de la protubérance est structurée en maillage.

Par maillage, on entend ici un ensemble de lignes assurant une redondance dans le scellement, de manière à ce qu'un défaut de fabrication éventuel dans une ligne de scellement ne puisse pas compromettre l'herméticité du scellement.

L'invention vise également une microstructure comprenant une zone de scellement telle que décrite succinctement ci-dessus.

D'autres aspects et avantages de l'invention apparaîtront à la lecture de la description détaillée, que l'on trouvera ci-dessous, de modes particuliers de réalisation donnés à titre d'exemples non limitatifs. Cette description se réfère aux dessins annexés, dans lesquels :
- la figure 1 est une vue en coupe de l'ensemble résultant de l'assemblage d'un substrat inférieur et d'un substrat central après formation d'un liseré de scellement,
- la figure 2 est une vue agrandie d'un détail de cette figure 1,
- la figure 3 est une vue en coupe de l'ensemble résultant de l'assemblage du substrat inférieur et du substrat central après libération de la partie sensible,
- la figure 4 est une vue en coupe d'un substrat supérieur,
- la figure 5 en est une vue de dessous,
- la figure 6 est une vue en coupe du substrat supérieur après creusement d'une cavité,
- la figure 7 est une vue en perspective agrandie d'un détail de la figure 5,
- la figure 8 est une vue en perspective agrandie d'une variante selon l'invention du même détail de la figure 5,
- la figure 9 est une vue en coupe d'une microstructure du type géophone en voie d'achèvement, et
- la figure 10 est un schéma de principe, en coupe, du scellement d'un substrat sur un autre, dont la figure 9 est une application particulière.

On va décrire à présent diverses étapes de la fabrication d'une microstructure adaptée à la mise en oeuvre de l'invention. Cette microstructure peut par exemple être un accéléromètre, notamment un « géophone ». Les « géophones » sont des accéléromètres de grande sensibilité utilisés pour détecter les réactions d'un sol suite à des secousses qui lui sont appliquées, par exemple pour les besoins de la prospection pétrolière.

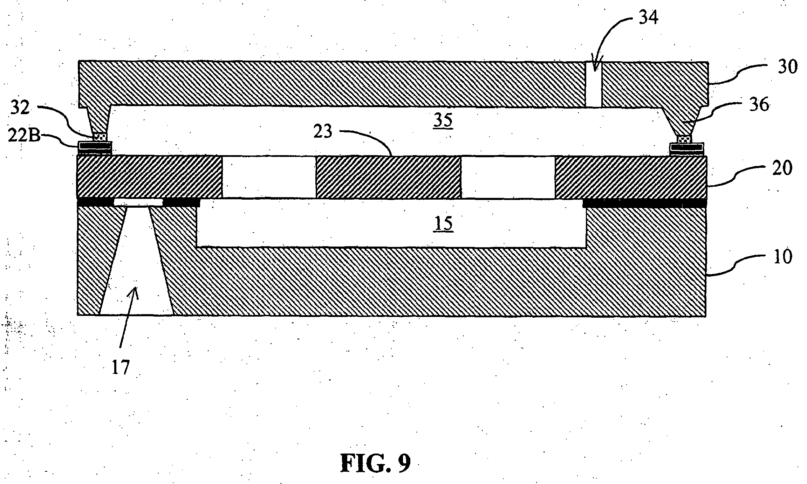

La figure 9 représente un géophone comportant au moins trois parties principales: une partie centrale (comprenant une zone sensible, telle qu'une masse mobile sensible aux accélérations à détecter par le géophone), une partie « inférieure » qui porte cette partie centrale, et une partie « supérieure » qui recouvre cette partie centrale et qui définit avec la partie inférieure une enceinte dans laquelle il est possible de faire le vide. Chacune de ces parties est réalisée à partir d'un substrat (portant respectivement le numéro de référence 20, 10 et 30), ici en silicium, selon des techniques décrites par exemple dans les brevets FR-2 558 263 et FR-2 770 339.

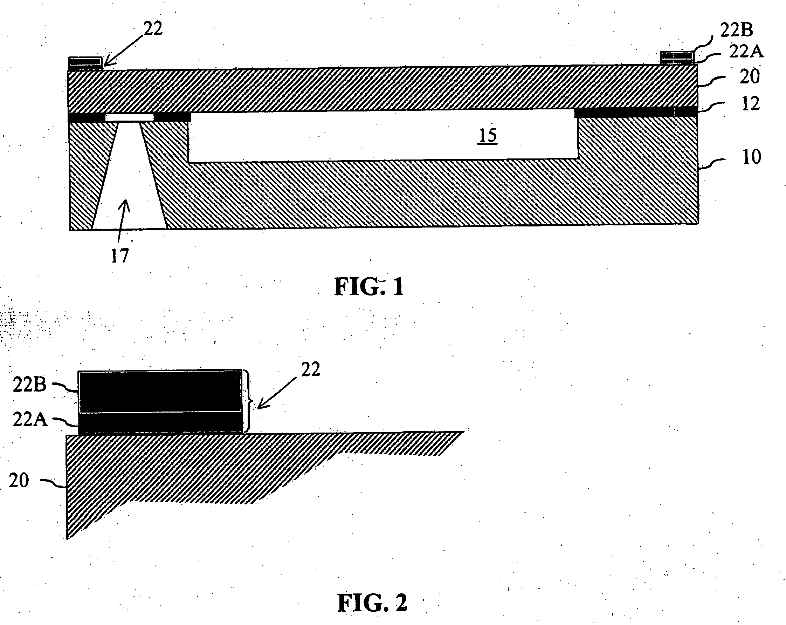

L'ensemble de la figure 9 est obtenu après une série d'étapes, dont les premières concernent l'assemblage et la préparation des substrats 10 et 20. Ces étapes sont illustrées sur les figures 1 à 3.

Comme le montre la figure 1, le substrat 20 se présente sous la forme d'une couche mince qui a été rapportée sur le substrat 10, dans lequel une cavité 15 a été préalablement aménagée. De manière préférée, la couche mince est reportée sur le substrat 10 par la technique du collage moléculaire Si/SiO₂ sous vide: la couche 12 est une couche d'oxyde de silicium, qui sert également d'isolant entre la couche mince 20 et le substrat 10 ; selon cette technique de collage, un recuit ultérieur à haute température, par exemple à 1100 °C, permet un renforcement du scellement.

Conformément à la présente invention, on procède par ailleurs, sur la surface supérieure de la couche mince 20, au dépôt d'un liseré 22 entourant notamment la portion de la couche mince surplombant la cavité, ici formé (voir la figure 2 à grande échelle) de la superposition d'un liseré 22A et d'un liseré 22B. Dans l'exemple ici considéré, ces deux liserés ont la même largeur.

Le liseré, ou cordon, supérieur 22B est ici en or, et est destiné à une fixation étanche du substrat supérieur 30 sur l'ensemble constitué par le substrat inférieur 10 et le substrat central 20. Le choix de l'or s'explique par le fait que l'or et le silicium diffusent facilement l'un dans l'autre, et que dans notre cas, le substrat supérieur 30 est, de préférence, en silicium. Le liseré, ou cordon, inférieur 22A sert de couche d'adhésion, et de plus fait barrière à la diffusion du matériau constitutif du liseré supérieur dans la matière constituant la couche mince 20. Ce liseré 22A est ici en tungstène.

Les dimensions de ces deux couches 22A et 22B sont avantageusement calibrées avec précision au moyen d'une gravure propre à délimiter leurs largeurs et plus généralement leurs formes.

On perce ensuite le substrat 10 sur sa face externe, en une zone décalée par rapport à la cavité 15, de manière à aménager un puits 17. A cet effet, on procède à un traitement de gravure du substrat 10 sur toute son épaisseur. Ce traitement est ici une gravure anisotrope à la potasse (KOH), ce qui se traduit par une section du puits 17 qui diminue vers le haut, c'est à dire vers la couche mince. Cette attaque est poursuivie jusqu'au travers de la couche d'oxyde 12, en pratique par une technique de gravure chimique, par exemple à l'acide fluorhydrique (HF), ce qui permet d'obtenir un retrait de la couche d'oxyde 12 sous les bords du puits 17, et donc un surplomb de ces bords vis-à-vis de la couche mince 20.

Le puits 17 est destiné au passage d'une prise de contact électrique par la face « arrière » de la microstructure, comme enseigné dans le brevet FR-2 770 339, ce qui facilite ensuite la réalisation d'un scellement hermétique à « l'avant ». On a représenté un seul puits 17 sur les figures, mais de manière générale, on prévoira plusieurs puits de contact similaires en fonction du nombre de connexions électriques à établir avec la couche mince 20. Dans l'exemple considéré ici, les puits sont identiques, et ont une section carrée.

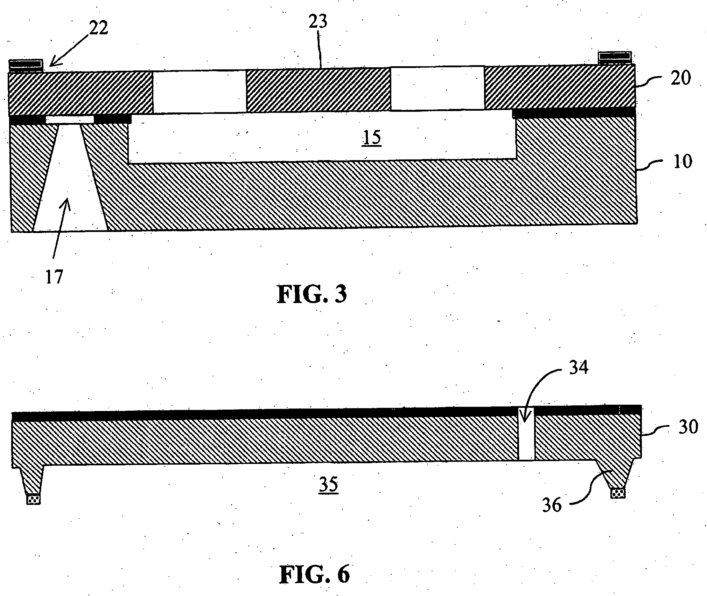

Comme le montre la figure 3, on découpe ensuite dans la couche mince 20 une « partie sensible » 23 au-dessus de la cavité 15. Cette découpe peut par exemple être réalisée par gravure sèche, en sorte de détourer mécaniquement et électriquement cette partie sensible. Dans la microstructure considérée ici, cette partie sensible est destinée, en service, à osciller vis-à-vis du reste de la couche mince 20.

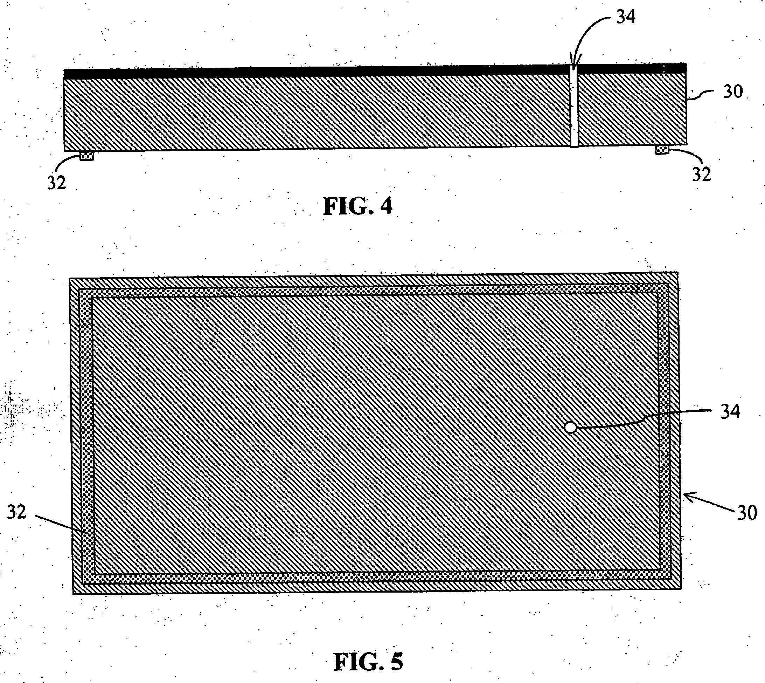

Les figures 4 et 5 représentent le substrat supérieur 30 dans une première étape de préparation. On observe, en partie droite de ce substrat 30, un étroit canal vertical, ou évent 34, traversant le substrat dans toute son épaisseur. Il est ici réalisé par gravure ultrasonique, ou gravure sèche DRIE (initiales des mots anglais « *Deep Reactive Ion Etching* », c'est-à-dire « Gravure Profonde à Réaction Ionique »).

Conformément à la présente invention, on dépose, sur l'une des faces du substrat 30, un liseré 32 selon un motif permettant, au moment du scellement, la mise en contact de ce liseré 32 avec le liseré 22 qui a été déposé sur la couche mince 20. Ce liseré a été déposé ici par dépôt sous vide en phase vapeur ou par pulvérisation par exemple, avant d'être mis en forme par gravure.

Ce liseré 32 est en un matériau interdiffusant aisément avec la matière constitutive du substrat supérieur 30 ainsi qu'avec le matériau de la couche supérieure 22B du liseré 22. Les liserés 22B et 32 sont avantageusement dans le même matériau ; dans l'exemple considéré, ils sont tous deux en or.

Après une étape de gravure, pour laquelle le liseré 32 a servi de masque, on obtient, sur une partie de l'épaisseur de ce substrat 30, une cavité 35 entourée par une paroi continue 36, comme illustré sur la figure 6.

Les flancs de cette paroi en saillie 36 sont ici inclinés ; en effet, la gravure de la cavité 35 a été réalisée par gravure humide, mais d'autres technologies sont possibles (notamment gravure sèche DRIE).

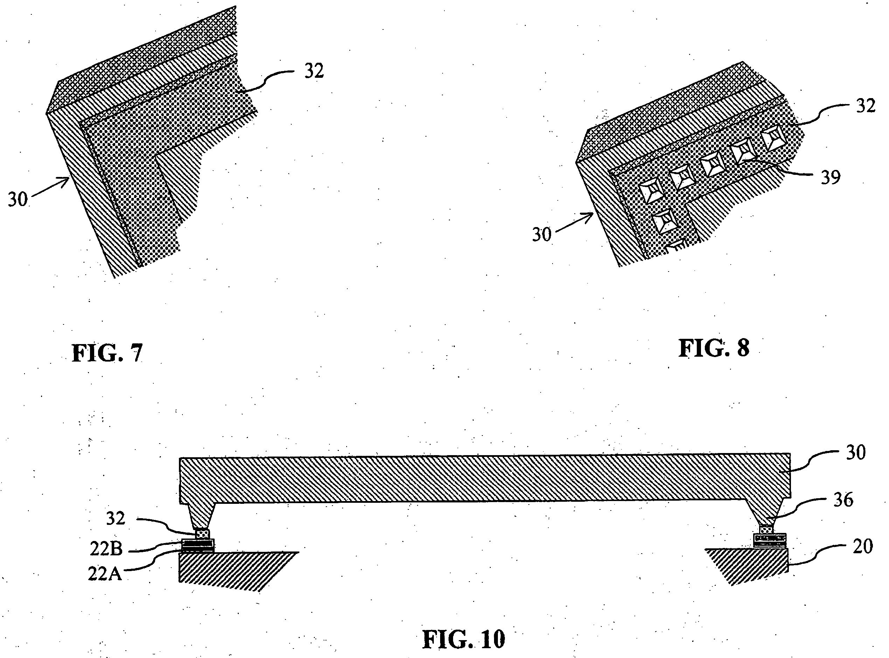

Le liseré 32 peut être réalisé selon différentes modalités. En vue en perspective à grande échelle (figure 7), la surface inférieure du substrat 30, revêtue du liseré 32 de la figure 4, est lisse. En variante selon l'invention représentée à la figure 8, cette surface comporte avantageusement des réseaux ou maillages plus ou moins complexes de creux 39, ici disposés selon un alignement s'étendant au milieu du liseré 32, et s'étendant en pratique au travers du liseré 32 jusque dans le substrat 30 lui-même.

Ces creux sont ici de forme de pyramide tronquée, avec des parois inclinées. Ils peuvent en effet être réalisés par gravure humide, par exemple à la potasse, au travers d'un masque non représenté (d'où les parois inclinées d'un angle ici de l'ordre de 54°). En variante non représentée, les creux peuvent avoir une forme rectangulaire, ronde ou autre, et avoir une section constante. En outre, ils peuvent former un réseau comportant plusieurs alignements, en quinconce ou non, parallèles ou non à la ligne médiane du liseré. En tout état de cause, quelle que soit la configuration choisie, il n'y a avantageusement aucun passage traversant la paroi 36, ce qui garantit l'étanchéité du scellement.

On va décrire à présent un certain nombre de caractéristiques préférées du procédé et de la zone de scellement selon l'invention.

La figure 9 montre le substrat supérieur 30 de la figure 6 positionné sur l'ensemble de la figure 3. Les cavités 15 et 35 ont entre autres pour effet, dans le cadre de l'application envisagée ici (mesure des accélérations de la partie sensible 23 par variation de capacité), d'éviter la formation de capacités parasites. L'évent 34 permet de faire le vide dans l'enceinte.

Le liseré 32 a ici une largeur inférieure à celle du liseré supérieur 22B ménagé à la périphérie de la couche mince ; de plus, son épaisseur (dimension verticale sur cette figure) est de préférence inférieure à celle du liseré supérieur 22B (par exemple, 0,1 µm pour le liseré 32, et 1 µm, pour le liseré 22B).

Le scellement de l'ensemble est réalisé par traitement thermique à une température de l'ordre de 400 °C, en sorte de faire diffuser le matériau constitutif des liserés 22B et 32 en profondeur dans l'épaisseur de la paroi 36, ce qui correspond ici à faire diffuser l'or vers le haut dans la paroi en silicium : le liseré 22B est fixé, par construction, à la couche mince ; étant ici de même nature que le matériau constitutif du liseré 32, ce liseré 22B se scelle spontanément au liseré 32, et l'interdiffusion de l'or contenu dans ces liserés avec le silicium de la paroi 36 assure le scellement de cette paroi à la couche mince (le liseré 32 sert d'amorce et le liseré 22B sert de réserve). L'efficacité de ce scellement découle notamment de l'existence d'un eutectique Au-Si, ce qui garantit une forte tendance de l'or à se lier aux atomes de silicium de la paroi. Sans vouloir être lié à un phénomène, il semblerait que le scellement obtenu résulte même de la formation d'un tel eutectique dans la masse de la paroi, malgré le fait que la concentration de l'or dans le silicium varie sans doute en fonction de l'éloignement à l'interface entre cette paroi et la couche mince.

Les dimensions du liseré 22B sont suffisantes pour garantir qu'il y ait suffisamment d'or disponible pour diffuser dans le silicium et assurer un bon scellement. Toutefois, cette quantité est limitée par le fait que la zone du substrat supérieur 30 dans laquelle cet or diffuse (la protubérance 36) est étroite. Ce liseré 22B assure donc bien une fonction de « réserve » pour ce scellement. On rappelle que le liseré 22A forme une barrière empêchant cet or de diffuser vers l'intérieur de la couche mince 20, de sorte qu'aucune consommation d'or ne peut se produire de ce côté.

Le scellement obtenu s'est révélé présenter une bonne étanchéité (aux liquides et aux gaz). De plus, il s'est révélé être toujours très robuste.

On notera également que ce scellement peut être obtenu soit sous vide, soit sous pression gazeuse contrôlée.

Pour conclure, on a représenté sur la figure 10 le principe général de ce scellement au moyen de deux éléments chimiques capables de former un eutectique. Le procédé selon l'invention met en oeuvre, du côté d'un premier substrat 20, un liseré 22 à deux couches dont la forme correspond au contour selon lequel on veut obtenir un scellement et, sur un second substrat 30, un liseré 32 en regard, disposé sur la tranche d'un contour en saillie 36. La couche supérieure 22B du premier liseré et le second liseré 32 sont en principe en un même matériau, dit matériau de scellement, apte à interdiffuser facilement avec la matière constitutive du contour en saillie 36, et la couche inférieure 22A du premier liseré est en une matière à travers laquelle le matériau de scellement n'a pas tendance à diffuser. Si le contour en saillie est en Si, le premier matériau est avantageusement en Au. Sans vouloir être lié à cette explication, il est supposé que le scellement à température modérée résulte de l'obtention d'un eutectique Au-Si. Le second liseré sert d'amorce au phénomène, lequel est entretenu par consommation de la couche supérieure du premier liseré, qui sert ainsi de réserve. Les gradients de concentration impliquent que la composition eutectique n'est pas uniformément obtenue.

La présente invention ne se limite pas aux modes de réalisation décrits ci-dessus: en fait, l'homme de l'art pourra mettre en oeuvre diverses variantes de l'invention tout en restant à l'intérieur de la portée des revendications ci jointes. Notamment, le dispositif de maintien du vide selon l'invention pourra être placé de manière adéquate dans divers systèmes destinés à fonctionner sous vide, autres que les accéléromètres décrits ici à titre d'exemple.

## Revendications

1. Procédé de scellement de deux substrats dans une microstructure, **caractérisé en ce qu'**il comprend les étapes suivantes :
- on dépose à la surface d'un premier substrat (20) un premier liseré (22) comprenant un liseré « supérieur » (22B) constitué d'une couche de matériau de scellement apte à interdiffuser spontanément avec la matière du second substrat (30), et un liseré « inférieur » (22A) constitué d'une matière d'adhésion apte à faire adhérer ledit premier substrat (20) avec ledit matériau de scellement,
- et on dépose, à la surface du second substrat (30) en regard du premier liseré (22), un second liseré (32) constitué d'une couche dudit matériau de scellement apte à interdiffuser avec le matériau du second substrat,
- le second liseré (32) étant à la surface d'au moins une protubérance (36) formée par gravure sur une partie de l'épaisseur dudit second substrat, ladite protubérance, dont la surface comporte des réseaux ou maillages de creux, étant apte à canaliser la diffusion du matériau de scellement, on met au contact les deux parties à assembler, et
- on chauffe la zone de scellement de manière à obtenir l'interdiffusion du matériau de scellement du premier et du second liserés avec la matière du second substrat (30), la protubérance canalisant la diffusion du matériau de scellement.

2. Procédé de scellement selon la revendication 1 **caractérisé en ce qu'**on effectue une étape de gravure pour laquelle le second liseré sert de masque et qu'on obtient ainsi une protubérance (36) formée sur le second substrat.

3. Procédé de scellement selon la revendication 1 ou la revendication 2, **caractérisé en ce que** les dimensions du liseré « supérieur » (22B) du premier liseré sont telles que le liseré « supérieur » forme une réserve de matériau de scellement apte à diffuser dans le matériau du second substrat.

4. Procédé de scellement selon l'une des revendications 1 à 3, **caractérisé en ce que** ledit matériau de scellement et la matière dudit premier substrat (20) sont de nature à pouvoir diffuser l'un dans l'autre, et **en ce que** ledit liseré inférieur (22A) fait barrière à cette diffusion.

5. Procédé de scellement selon l'une des revendications 1 à 4, **caractérisé en ce que** ledit matériau de scellement et la matière dudit premier substrat (20) sont de nature à pouvoir diffuser l'un dans l'autre, et **en ce que** ledit premier liseré (22) comprend en outre, entre ledit liseré inférieur (22A) et ledit liseré supérieur (22B), une couche faisant barrière à cette diffusion.

6. Procédé de scellement selon l'une quelconque des revendications précédentes, **caractérisé en ce que** le premier substrat (20) est en silicium.

7. Procédé de scellement selon l'une quelconque des revendications précédentes, **caractérisé en ce que** le second substrat (30) est en silicium.

8. Procédé de scellement selon l'une quelconque des revendications précédentes, **caractérisée en ce que** ledit matériau de scellement est de l'or.

9. Procédé de scellement selon la revendication 4 ou la revendication 5, **caractérisé en ce que** ladite couche barrière est en tungstène.

10. Zone de scellement entre deux substrats d'une microstructure, **caractérisée en ce qu'**elle comprend au moins les parties suivantes :
- sur un premier substrat (20), un liseré « inférieur » (22A) constitué d'une matière d'adhésion apte à faire adhérer ledit premier substrat (20) avec un matériau de scellement, ledit matériau de scellement étant apte à interdiffuser spontanément avec la matière du second substrat (30),
- sur ledit liseré inférieur (22A), une couche dudit matériau de scellement, et
- sur ladite couche de matériau de scellement, une protubérance (36) formée par gravure sur une partie de l'épaisseur dudit second substrat (30), apte à canaliser la diffusion du matériau de scellement, dont la surface comporte des réseaux ou maillages de creux, et contenant une certaine quantité de matériau de scellement.

11. Zone de scellement selon la revendication 10, **caractérisée en ce que** ledit matériau de scellement et la matière dudit premier substrat (20) sont de nature à pouvoir diffuser l'un dans l'autre, et **en ce que** ledit liseré inférieur (22A) fait barrière à cette diffusion.

12. Zone de scellement selon la revendication 10, **caractérisée en ce que** ledit matériau de scellement et la matière dudit premier substrat (20) sont de nature à pouvoir diffuser l'un dans l'autre, et **en ce que** ladite zone de scellement comprend en outre, entre ledit liseré inférieur (22A) et ladite couche de matériau de scellement, une couche faisant barrière à cette diffusion.

13. Zone de scellement selon l'une quelconque des revendications 9 à 12, **caractérisée en ce que** ladite surface de la protubérance (36) n'est pas plane, mais présente un certain nombre de creux (39).

14. Zone de scellement selon l'une quelconque des revendications 9 à 13, **caractérisée en ce que** la surface de ladite protubérance (36) est structurée en maillage.

15. Zone de scellement selon l'une quelconque des revendications 9 à 14, **caractérisée en ce que** le premier substrat (20) est en silicium.

16. Zone de scellement selon l'une quelconque des revendications 9 à 15, **caractérisée en ce que** le second substrat (30) est en silicium.

17. Zone de scellement selon l'une quelconque des revendications 9 à 16, **caractérisée en ce que** ledit matériau de scellement est de l'or.

18. Zone de scellement selon la revendication 11 ou la revendication 12, **caractérisée en ce que** ladite couche barrière est en tungstène.

19. Microstructure comprenant une zone de scellement selon l'une quelconque des revendications 10 à 18.

## Patentansprüche

1. Verfahren zum Verschließen von zwei Substraten in einer Mikrostruktur, **dadurch gekennzeichnet, dass** es die folgenden Schritte umfasst:
- an der Oberfläche eines ersten Substrats (20) wird eine erste Randeinfassung (22) abgeschieden, die eine "obere" Randeinfassung (22B) bestehend aus einer Schicht aus Verschlussmaterial, das geeignet ist, mit dem Material des zweiten Substrats (30) spontan zu interdiffundieren, und eine "untere" Randeinfassung (22A) bestehend aus einem Haftmaterial, das geeignet ist, das erste Substrat (20) mit dem Verschlussmaterial zu verkleben, umfasst, und
- an der Oberfläche des zweiten Substrats (30), gegenüber der ersten Randeinfassung (22), wird eine zweite Randeinfassung (32) bestehend aus einer Schicht aus dem Verschlussmaterial, das geeignet ist, mit dem Material des zweiten Substrats zu interdiffundieren, abgeschieden,
- wobei die zweite Randeinfassung (32) sich an der Oberfläche wenigstens eines Vorsprungs (36), der durch Ätzen über einen Teil der Dicke des zweiten Substrats gebildet ist, befindet, wobei der Vorsprung, dessen Oberfläche Netze oder Maschenstrukturen aus Vertiefungen aufweist, geeignet ist, die Diffusion des Verschlussmaterials zu kanalisieren, die beiden zusammenzufügenden Teile werden in Kontakt gebracht, und
- der Verschlussbereich wird erhitzt, um das Interdiffundieren des Verschlussmaterials der ersten und der zweiten Randeinfassung mit dem Material des zweiten Substrats (30) zu erhalten, wobei der Vorsprung die Diffusion des Verschlussmaterials kanalisiert.

2. Verschlussverfahren nach Anspruch 1, **dadurch gekennzeichnet, dass** ein Ätzschritt durchgeführt wird, für den die zweite Randeinfassung als Maske dient, und dass so ein auf dem zweiten Substrat gebildeter Vorsprung (36) erhalten wird.

3. Verschlussverfahren nach Anspruch 1 oder Anspruch 2, **dadurch gekennzeichnet, dass** die Abmessungen der "oberen" Randeinfassung (22B) der ersten Randeinfassung derart sind, dass die "obere" Randeinfassung eine Verschlussmaterialreserve bildet, die geeignet ist, in das Material des zweiten Substrats zu diffundieren.

4. Verschlussverfahren nach einem der Ansprüche 1 bis 3, **dadurch gekennzeichnet, dass** das Verschlussmaterial und das Material des ersten Substrats (20) der Art sind, dass sie ineinander diffundieren können, und dass die untere Randeinfassung (22A) eine Sperre gegen diese Diffusion bildet.

5. Verschlussverfahren nach einem der Ansprüche 1 bis 4,**dadurch gekennzeichnet, dass** das Verschlussmaterial und das Material des ersten Substrats (20) der Art sind, dass sie ineinander diffundieren können, und dass die erste Randeinfassung (22) ferner zwischen der unteren Randeinfassung (22A) und der oberen Randeinfassung (22B) eine eine Sperre gegen diese Diffusion bildende Schicht umfasst.

6. Verschlussverfahren nach einem der vorhergehenden Ansprüche, **dadurch gekennzeichnet, dass** das erste Substrat (20) aus Silicium besteht.

7. Verschlussverfahren nach einem der vorhergehenden Ansprüche, **dadurch gekennzeichnet, dass** das zweite Substrat (30) aus Silicium besteht.

8. Verschlussverfahren nach einem der vorhergehenden Ansprüche, **dadurch gekennzeichnet, dass** das Verschlussmaterial Gold ist.

9. Verschlussverfahren nach Anspruch 4 oder Anspruch 5, **dadurch gekennzeichnet, dass** die Sperrschicht aus Wolfram besteht.

10. Verschlussbereich zwischen zwei Substraten einer Mikrostruktur,
**dadurch gekennzeichnet, dass** er wenigstens die folgenden Teile umfasst:
- auf einem ersten Substrat (20) eine "untere" Randeinfassung (22A) bestehend aus einem Haftmaterial, das geeignet ist, das erste Substrat (20) mit einem Verschlussmaterial zu verkleben, wobei das Verschlussmaterial geeignet ist, mit dem Material des zweiten Substrats (30) spontan zu interdiffundieren,
- auf der unteren Randeinfassung (22A) eine Schicht aus dem Verschlussmaterial und
- auf der Schicht aus Verschlussmaterial einen Vorsprung (36), der durch Ätzen über einen Teil der Dicke des zweiten Substrats (30) gebildet ist, der geeignet ist, die Diffusion des Verschlussmaterials zu kanalisieren, dessen Oberfläche Netze oder Maschenstrukturen aus Vertiefungen aufweist und der eine gewisse Menge an Verschlussmaterial enthält.

11. Verschlussbereich nach Anspruch 10, **dadurch gekennzeichnet, dass** das Verschlussmaterial und das Material des ersten Substrats (20) der Art sind, dass sie ineinander diffundieren können, und dass die untere Randeinfassung (22A) eine Sperre gegen diese Diffusion bildet.

12. Verschlussbereich nach Anspruch 10, **dadurch gekennzeichnet, dass** das Verschlussmaterial und das Material des ersten Substrats (20) der Art sind, dass sie ineinander diffundieren können, und dass der Verschlussbereich ferner zwischen der unteren Randeinfassung (22A) und der Schicht aus Verschlussmaterial eine eine Sperre gegen diese Diffusion bildende Schicht umfasst.

13. Verschlussbereich nach einem der Ansprüche 9 bis 12, **dadurch gekennzeichnet, dass** die Oberfläche des Vorsprungs (36) nicht eben ist, sondern eine gewisse Anzahl von Vertiefungen (39) aufweist.

14. Verschlussbereich nach einem der Ansprüche 9 bis 13, **dadurch gekennzeichnet, dass** die Oberfläche des Vorsprungs (36) als Maschenstruktur strukturiert ist.

15. Verschlussbereich nach einem der Ansprüche 9 bis 14, **dadurch gekennzeichnet, dass** das erste Substrat (20) aus Silicium besteht.

16. Verschlussbereich nach einem der Ansprüche 9 bis 15, **dadurch gekennzeichnet, dass** das zweite Substrat (30) aus Silicium besteht.

17. Verschlussbereich nach einem der Ansprüche 9 bis 16, **dadurch gekennzeichnet, dass** das Verschlussmaterial Gold ist.

18. Verschlussbereich nach Anspruch 11 oder Anspruch 12, **dadurch gekennzeichnet, dass** die Sperrschicht aus Wolfram besteht.

19. Mikrostruktur, die einen Verschlussbereich nach einem der Ansprüche 10 bis 18 umfasst.

## Claims

1. A method of sealing two substrates in a microstructure, **characterized in that** it comprises the following steps:
- there is deposited onto the surface of a first substrate (20) a first rim (22) comprising an "upper" rim (22B) consisting of a layer of sealing material adapted to interdiffuse spontaneously with the material of the second substrate (30) and a "lower" rim (22A) consisting of an adhesion material adapted to cause said first substrate (20) to adhere to said sealing material,
- and there is deposited onto the surface of the second substrate (30) facing the first rim (22) a second rim (32) consisting of a layer of said sealing material adapted to interdiffuse with the material of this second substrate,
- the second rim (32) being at the surface of at least one protuberance (36) formed by etching at least a part of the thickness of said second substrate, the protuberance, the surface of which features arrays or meshes of hollows, being adapted to channel the diffusion of the sealing material, the two portions to be assembled are brought into contact, and
- the sealing region is heated to obtain the interdiffusion of the sealing material of the first and second rims with the material of the second substrate (30), the protuberance channeling the diffusion of the sealing material.

2. Sealing method according to claim 1 **characterized in that** an etching step is conducted in which the second rim serves as a mask and a protuberance (36) is thus obtained on the second substrate.

3. Sealing method according to claim 1 or claim 2, **characterized in that** the dimensions of the "upper" rim (22B) are such that the "upper" rim provides a reserve of sealing material adapted to diffuse in the material of the second substrate.

4. Sealing method according to one of claims 1 to 3, **characterized in that** said sealing material and the material of said first substrate (20) are able to diffuse into each other and **in that** said lower rim (22A) forms a barrier to this diffusion.

5. Sealing method according to one of claims 1 to 4, **characterized in that** said sealing material and the material of said first substrate (20) are able to diffuse into each other and **in that** said first rim (22) further comprises a layer forming a barrier to this diffusion between said lower rim (22A) and said upper rim (22B).

6. Sealing method according to any preceding claim, **characterized in that** the first substrate (20) is of silicon.

7. Sealing method according to any preceding claim, **characterized in that** the second substrate (30) is of silicon.

8. Sealing method according to any preceding claim, **characterized in that** said sealing material is gold.

9. Sealing method according to claim 4 or claim 5, **characterized in that** said barrier layer is of tungsten.

10. Sealing region between two substrates of a microstructure, **characterized in that** it comprises at least the following portions:
- on a first substrate (20), a "lower" rim (22A) consisting of an adhesion material adapted to cause said first substrate (20) to adhere to a sealing material, this sealing material being adapted to interdiffuse spontaneously with the material of the second substrate (30),
- on said lower rim (22A), a layer of said sealing material, and
- on said sealing material layer, a protuberance (36) formed by etching a part of the thickness of said second substrate (30), adapted to channel the diffusion of the sealing material, the surface of which features arrays or meshes of hollows and containing a certain quantity of sealing material.

11. Sealing region according to claim 10, **characterized in that** said sealing material and the material of said first substrate (20) are able to diffuse into each other and **in that** said lower rim (22A) forms a barrier to this diffusion.

12. Sealing region according to claim 10, **characterized in that** said sealing material and the material of said first substrate (20) are able to diffuse into each other and **in that** said sealing region further comprises a layer forming a barrier to this diffusion between said lower rim (22A) and said layer of sealing material.

13. Sealing region according to any of claims 9 to 12, **characterized in that** said surface of the protuberance (36) is not plane, but features a certain number of hollows (39).

14. Sealing region according to any of claims 9 to 13, **characterized in that** the surface of said protuberance (36) has a meshed structure.

15. Sealing region according to any of claims 9 to 14, **characterized in that** the first substrate (20) is of silicon.

16. Sealing region according to any of claims 9 to 15, **characterized in that** the second substrate (30) is of silicon.

17. Sealing region according to any of claims 9 to 16, **characterized in that** said sealing material is gold.

18. Sealing region according to claim 11 or claim 12, **characterized in that** said barrier layer is of tungsten.

19. Microstructure comprising a sealing region according to any of claims 10 to 18.
